# EUROPEAN PATENT APPLICATION

(11) **EP 1 818 992 A1**
(43) Date of publication of application: **15.08.2007**
(21) Application number: 06075277.1
(22) Date of filing: 08.02.2006
(51) Int. Cl.: H01L 35/24, H01L 31/04, H01L 51/42, H01L 35/00

(54) **Thermally insulating thermoelectric roofing element**

(71) Applicant: Nederlandse Organisatie voor toegepast- natuurwetenschappelijk onderzoek TNO, 2628 VK Delft (NL)
(72) Inventor: Nijboer, Christiaan Aloysius Jozef, 2512 CT Den Haag (TH)
(74) Representative: Winckels, Johannes Hubertus F.

(57) **Abstract**

Thermally insulating roofing element, comprising a plurality of thermoelectric elements, each comprising a first conductor (1), made of a first conductive material, and a second conductor (2), made of a second conductive material, both conductors mainly extending between the element's flat sides (12, 13) and being electrically interconnected by at least one junction (3, 4). The first conductive material may be a first conductive polymer and the second conductive material a second conductive polymer. One or more support bodies (6), having thermal and electrical isolating properties, support the first and/or second conductors. The support bodies mainly extends in the length or the width of the roof element and may be made of an isolating polymer.

## Description

### Field

The invention concerns the generation of electricy by means of temperature difference across the insulated roofing element.

### Background

Electricity for a building may be generated in a clean, affordable and reliable way by using the building's roof surface. Prior art systems may operate on the basis of PhotoVoltaic (PV) generation, converting (sun)light into electricity. These panels are installed during construction of the building, which leads to extra (installation) costs and some technical risks w.r.t. the roof construction, e.g. its water tightness due to cable guides etc. Moreover, PV panels influence the appearance of the roof. These factors restrict the application of the PV panels, leading to a relative low use of roofs for the generation of electricity.

Another method for local electricity generation is based on thermoelectricity. Up till now, the largest part of such thermoelectric systems is based on semiconductors like Bismuth Telluride (Bi₂Te₃) etc. These kind of materials are usually toxic, expensive and scarce. Furthermore, these materials are not appropriate for integration in roofs, in view of thermal conduction properties and, besides, such thermoelectric modules are not appropriate for integration in roofs due to their small dimensions.

### Summary

The present invention aims to provide a insulated roof element - e.g. a sandwich insulated roof boarding element - which combines good thermal properties with integrated thermoelectric power generation. To that end, the roof element comprises a plurality of thermoelectric elements, each comprising a first conductor, made of a first polymeric conductive material, and a second conductor, made of a second polymeric conductive material, both conductors of such thermoelectric element mainly extending between the element's flat sides and electrically interconnected.

The electricity is generated by using the Seebeck effect: when a circuit is formed by a junction of two dissimilar electrically conductive materials and the junctions are held at different temperatures, a current will flow in the circuit caused by the difference in temperature between the two junctions. In the present case use is made of the temperature difference between the outer (top) side of the roof element which is turned to the sun and thus gets a relative high temperature, especially when the roof boarding is e.g. covered by a (black) Ethylene-Diene-Propylene-Monomer (EPDM) roof system, and the inner (bottom) side of the roof element which has a lower (ambient) temperature.

Preferably, said first conductive material is a first conductive polymer and second conductive material a second conductive polymer. Both conductive polymers can be intrinsically conducting polymers or extrinsically conducting polymers. The first and second conductive polymer may chemically be different or may basically be equal but doped inversely e.g. by exposing the one polymer to a positive doping agent and the other one to a negative doping agent respectively.

The roof element preferably comprises support bodies inside the roof element, which have good thermal and electrical isolating properties and are arranged for supporting the first and/or second conductors which form the thermoelectric elements. The support bodies may mainly extend in the length or in the width of the roof element. The support bodies may be made of an electrically and thermally insulating polymer (e.g. Expanded Polystyrene) and the first and/or second conductive polymers may be applied on this support body by means of adhesion if the conductive polymers consist of a film. Alternatively, the conductive polymers may form a copolymer or copolymers respectively with the support body polymer (copolymerization), thus forming a conducting top-layer or relevant conducting top-layers respectively.

### Exemplary Embodiment

Figure 1 shows a third embodiment of a thermoelectric element stack, in bottom view and in cross-sectional view.
Figure 2 shows part of an integrated roof element in cross-sectional view.
Figure 3 shows part of an integrated roof element in bottom view.

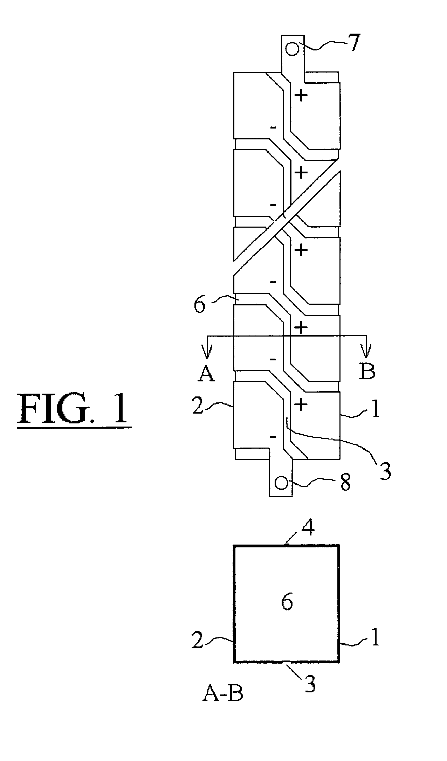

Figure 1 shows a bottom view and a cross-sectional view along the line A-B of a thermoelectric element stack which comprises a plurality of thermoelectric elements each formed by a first conductor 1, made of a first conductive material, and a second conductor 2, made of a second conductive material. The second conductor 2 comprises an electrically isolated gap 3 at the bottom side. Both conductors 1 and 2 are interconnected at a junction 4 at the top side. It will be presumed that the top side is the warm (rooftop) side - making junction 4 the "warm junction" - and the bottom side is the cold (inner building) side. The conductors 1 and 2 are supported by an isolation stack, serving as support body 6. The support body 6 may be made of an isolating polymer, e.g. expanded polystyrene. The first conductors 1 and the second conductors 2 may be made of conductive polymers (CPs), e.g. polyacetylene, polypyrrole, polyaniline, polythiophene of polyphenylene vinylene. The first and second conductors may be made of the same CPs, however one conductor doped with positive ions and the other conductor with negative ions, or made by different polymers. The CPs may form a film on top of the support body. Alternatively, the CPs may be chemically coupled with the support body polymer, in the form of a support body top-layer copolymer with preservation of the conductive properties.

Due to the Seebeck effect, when the top side and the bottom side are exposed to a temperature difference, an electric voltage (indicated by + and -) will occur over the gap 3 of each element formed by first conductor 1 and second conductor 2. By connecting all elements in series by interconnections as shown in the figure, all voltages generated by the individual elements of the whole stack 6 when the junctions 4 and 5 are exposed to a temperature difference, will be summed, which total voltage occurs over the clamps 7 and 8.

The main function of the support stacks 6 is the thermal insulation of the roof. The second function is supporting and separating the conductive layers forming the thermoelectric elements. The support stack 6 may be made of expanded polystyrene, supporting the first and second conductor layers 1 and 2, which may be made of e.g. polyaniline or polyacetylene. As an alternative the support stack could be made of PolyUtrethane hardfoam, forming a support body 'top-layer' copolymer with the CP. The first and second conductors and doped inversely to form a stack of series connected thermoelectric elements as shown.

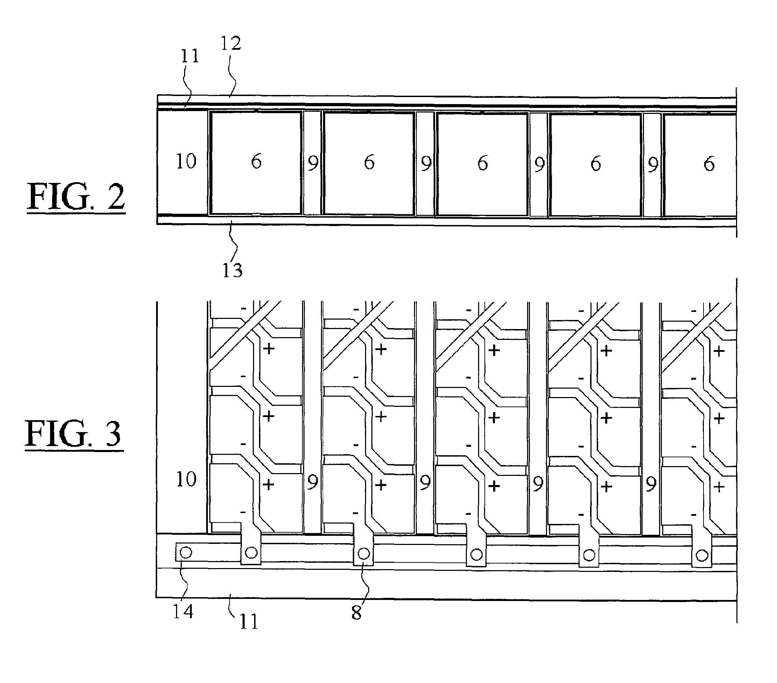

Figures 2 and 3 show parts of an integrated roof element. The cross-sectional view of figure 7 shows a couple of element stacks as shown in figure 6, separated by intermediate isolation members 9, as also shown in figure 2. The roof element may be surrounded by a (e.g. wooden) frame 10 and covered by a metal sheet 11 which is treated with an electrically isolating coating and top plate 12 of e.g. wood or a thermally conductive and light material. At the bottom side the roof element may be covered by a bottom plate 13 of e.g. wood or a thermally conductive and light material.

As figure 3 shows, the individual clamps 7 (not shown here) and 8 may be interconnected by interconnection strips 14 by which the element stacks may be connected in parallel (shown) or in series (not shown), depending on the Direct Current (DC) voltage generated by the combined element stacks, and the desired voltage for the conversion to Alternating Current (AC) present in the mains.

The temperature difference along the roof construction can in many cases amount to more than 50 K. Particularly in summer time the temperature on the top side (under e.g. a black EPDM layer) can probably amount to much above 70 degrees Celsius, whereas the bottom side of the isolated roof reaches about 25 degrees. However, even a small temperature difference (3-5 K) can already be sufficient for the generation of electricity.

## Claims

1. Thermally insulating roofing element, comprising a plurality of thermoelectric elements, each comprising a first conductor (1), made of a first conductive material, and a second conductor (2), made of a second conductive material, both conductors mainly extending between the roof element's flat sides (12, 13) and being electrically interconnected by at least one junction (3).

2. Roof element according to claim 1, said first conductive material being a first conductive polymer and said second conductive material being a second conductive polymer.

3. Roofing element according to claim 1, comprising one or more support bodies (6), having thermal and electrical isolating properties and supporting said first and/or second conductors.

4. Roofing element according to claim 3, said support bodies, mainly extending in the length or the width of the roof element.

5. Roofing element according to claim 3 or 4, comprising a series connection of said plurality of thermoelectric elements.

6. Roofing element according to claim 3, said support bodies being made of an isolating polymer.

7. Roofing element according to claims 1 and 3, said first and/or second conductors being applied to said one or more support bodies (6) by means of adhesion.

8. Roofing element according to claims 2 and 6, said first and/or second conductive polymers being applied to said one or more support bodies (6) by means of forming a relevant copolymer with the relevant support body polymer.
